# EUROPEAN PATENT SPECIFICATION

(11) **EP 0 468 868 B1**
(45) Date of publication and mention of the grant of the patent: **28.02.1996**
(21) Application number: 91402025.0
(22) Date of filing: 19.07.1991
(51) Int. Cl.: H01L 39/22, H01L 39/24

(54) **Superconducting device having a layered structure composed of oxide superconductor thin film and insulator thin film and method for manufacturing the same**
Supraleitende Einrichtung mit geschichteter Struktur, zusammengesetzt aus oxidischem Supraleiter und Isolatordünnschicht und deren Herstellungsmethode
Dispositif supraconducteur à structure laminée composée en couche mince en supraconducteur d'oxyde et de couche mince isolateur et sa méthode de fabrication

(30) Priority: 19.07.1990 JP 191174/90; 02.07.1991 JP 188075/91
(43) Date of publication of application: 29.01.1992
(73) Proprietor: SUMITOMO ELECTRIC INDUSTRIES, LTD., Osaka-shi, Osaka 541 (JP)
(72) Inventor: Saitoh, Mitsuchika, c/o Osaka Works, Konohana-ku, Osaka (JP); Tanaka, Sou, c/o Osaka Works, Konohana-ku, Osaka (JP); Iiyama, Michitomo, c/o Osaka Works, Konohana-ku, Osaka (JP)
(74) Representative: Bernasconi, Jean

(56) References cited:
- EP-A- 0 329 507
- EP-A- 0 342 038
- EP-A- 0 390 704
- EP-A- 0 430 798
- EP-A- 0 459 906
- PROCEEDINGS INTERNATIONAL ELECTRON DEVICES MEETING, 11 December 1988, San Francisco, US, pp. 282-285; A. YOSHIDA et al. : 'Monolithic device fabrication using high-Tc superconductor'
- APPLIED PHYSICS LETTERS, vol. 56, no. 15, 9 April 1990, New York, US, pp. 1469-1471; K. MIZUNO et al.: 'Fabrication of thin-film-type Josephson junctions using a Bi-Sr-Ca-Cu-O/Bi-Sr-Cu-O/Bi-Sr-Ca-Cu-O structure'
- MODERN PHYSICS LETTERS B, vol. 2, no. 10, 1988, pp. 1183-1188; A. TRESSAUD et al.

## Description

### Background of the Invention

### Field of the invention

The present invention relates to a superconductor-insulator-superconductor (SIS) Josephson tunnel device of oxide materials according to the first part of claim 1 and a method for manufacturing the superconducting device. A Josephson device of this type is disclosed in EP-A-0 342 038.

### Description of related art

In the case of using an oxide superconductor material in a superconducting device, it it necessary to form and stack a thin film of oxide superconductor material, and then, to form a thin film made for example of an insulator or a semiconductor, on the oxide superconductor material thin film. For example, when a superconductor/ insulator/superconductor junction called a "tunnel type" Josephson junction is formed by using an oxide superconductor material, it is necessary to sequentially stack a first thin film of oxide superconductor material, a thin film of insulator material, and a second thin film of oxide superconductor material in that order.

In this tunnel type Josephson junction, the thickness of the insulator material thin film is generally determined by the coherence length of the superconductor material. Since the oxide superconductor materials have a very short coherence length, it is necessary to utilize a non-superconductor material thin film having a thickness on the order of a few nanometres.

However, if the oxide superconductor material thin film is exposed to air, both superconductivity'and crystallinity will be deteriorated in the extent of about 1 nm depth from its surface. In ordinary cases, when a second thin film is deposited on the oxide superconductor material thin film, a deposition apparatus different from that used for the formation of the oxide superconductor material thin film is used, and therefore, the oxide superconductor material thin film is inevitably exposed to air in the course of transferring from a deposition apparatus to another deposition apparatus. Because of this, it has been a conventional practice to heat the oxide superconductor material thin film at about 700°C under an ultra-high vacuum on the order of 1.33 × 10⁻⁷ Pa (1 × 10⁻⁹ Torr), before the second thin film is deposited on the oxide superconductor material thin film.

The oxide superconductor material thin film subjected to the above mentioned heat-treatment can have a surface of an improved crystallinity, and in addition, it becomes possible to epitaxially grow the second thin film on the oxide superconductor material thin film. However, the heating of the oxide superconductor material thin film under the above mentioned ultra-high vacuum will result in loss of oxygen from the oxide superconductor material crystal thin film, which will deteriorate or lose the superconduction characteristics.

On the other hand, if the heat treatment is performed in oxygen atmosphere, no deterioration will occur in superconduction characteristics of the oxide superconductor material thin film, but the crystallinity of the thin film surface is not improved.

### Summary of the Invention

Accordingly, it is an object of the present invention to provide a superconducting device and a method of manufacturing the same, which will overcome the above mentioned defect of the conventional device and method.

Another object of the present invention is to provide a superconducting device having excellent characteristics and including an oxide superconductor material thin film of excellent superconductivity, and a method of manufacturing the same superconducting device.

The above and other objects of the present invention are achieved in accordance with the present invention by the superconducting device as defined in claim 1.

According to another aspect of the present invention, there is provided a method for manufacturing the above superconducting device.

This method is characterized in that after the first thin film of oxide superconductor material is formed on the substrate, the first thin film of oxide superconductor material is heat-treated in a gaseous atmosphere bringing a surface of the oxide superconductor material into an amorphous condition.

As seen from the above, the superconducting device in accordance with the present invention is characterized in that the second thin film of insulator formed on the first thin film of oxide superconductor material is formed of an amorphous oxide including the same constituent elements as those of the oxide superconductor material of the first thin film.

In the prior art, the amorphous oxide has been considered to have been formed because an oxide superconductor material exposed to air had reacted with the air. In other words, the amorphous oxide has been considered to have been formed as the result of the deterioration of the oxide superconductor material exposed to air. A precise composition of this amorphous oxide has not yet been clarified, but it is considered that because the crystal of the oxide superconductor material has been destroyed, the oxide superconductor material has become amorphous. The superconducting device in accordance with the present invention includes, as an insulator layer, a thin film of this amorphous oxide having a controlled thickness suitable for the superconducting device.

Therefore, in the superconducting device in accordance with the present invention, the insulator layer can be easily formed, and the insulator layer will give no adverse effect to the oxide superconductor material thin film, since the oxide superconductor material thin film and the amorphous oxide thin film are constituted of the same constituent elements.

Furthermore, the method in accordance with the present invention for manufacturing the above mentioned superconducting device of the present invention, is characterized in that after the first thin film of oxide superconductor material is formed on the substrate, the first thin film of oxide superconductor material is heat-treated in a gaseous atmosphere bringing a surface of the oxide superconductor material into an amorphous condition. The gas for bringing the oxide superconductor material into the amorphous condition can be exemplified by H₂O and CO₂. In this connection, when the heat-treatment is performed in a gaseous atmosphere including the above exemplified gas, the pressure is preferred to be in the range of 1.33 × 10⁻³ Pa (1×10⁻⁵ Torr) to 1.33 × 10⁻ Pa (1×10⁻⁴ Torr), and the heating temperature is preferably in the extent of 400°C to 800°C. Under this condition, the amorphous oxide thin film can be produced by wasting a few mono-layers of oxide superconductor surface, which are appropriate for a non-superconductor layer in a tunnel type Josephson device composed of an oxide superconductor material. Here, the term "monolayer" is used to mean a layer having a thickness corresponding to one atom.

If the heating temperature becomes high, decomposition or destruction of the surface region of the oxide superconductor material thin film is facilitated, and therefore, the surface of the oxide superconductor material is quickly brought into the amorphous condition. Therefore, it can be generally said that the higher the heating temperature, the shorter the required heat-treatment time. Preferably, the required heat-treatment time is not less than 5 minutes but not greater than 4 hours. However, if the heating temperature is greater than 800°C, the oxide superconductor material thin film itself is subjected to an adverse influence. In addition, in order to avoid a mutual diffusion between adjacent layers, and in order to form a sharp boundary between the oxide superconductor material thin film and the amorphous oxide thin film, it is preferred to perform the heat-treatment at a temperature not greater than 600°C. On the other hand, if the heating temperature is less than 400°C, the surface of the oxide superconductor material is not sufficiently brought into the amorphous condition.

In the method of the present invention, it is preferred to additionally heat-treat the oxide superconductor material thin film in an oxygen atmosphere after the heat-treatment is performed in the above mentioned gaseous atmosphere. The reason for this is the following : If the heat-treatment is performed in the above mentioned gaseous atmosphere, the superconductivity of the oxide superconductor material is deteriorated in some cases. The deteriorated oxide superconductor material thin film is improved by the additional heat-treatment in the oxygen atmosphere. This additional heat-treatment is performed under a pressure in the range of preferably 6.66 × 10³ Pa (50 Torr) to 2.67 × 10⁴ Pa (200 Torr), and at the heating temperature in the range of preferably 400°C to 500°C.

In the superconducting device and the manufacturing method of the present invention, any arbitrary oxide superconductor material can be used. But, a Y₁Ba₂Cu₃O_{7.x} (0≤x<1) type oxide superconductor is preferred, since a thin film having a high quality and a good crystallinity can be stably obtained. In addition, a Bi₂Sr₂Ca₂Cu₃Oy (7≤y≤11) type oxide superconductor is preferred, since it has a high superconduction critical temperature Tc.

The above and other objects, features and advantages of the present invention will be apparent from the following description of preferred embodiments of the invention with reference to the accompanying drawings.

### Brief Description of the Drawings

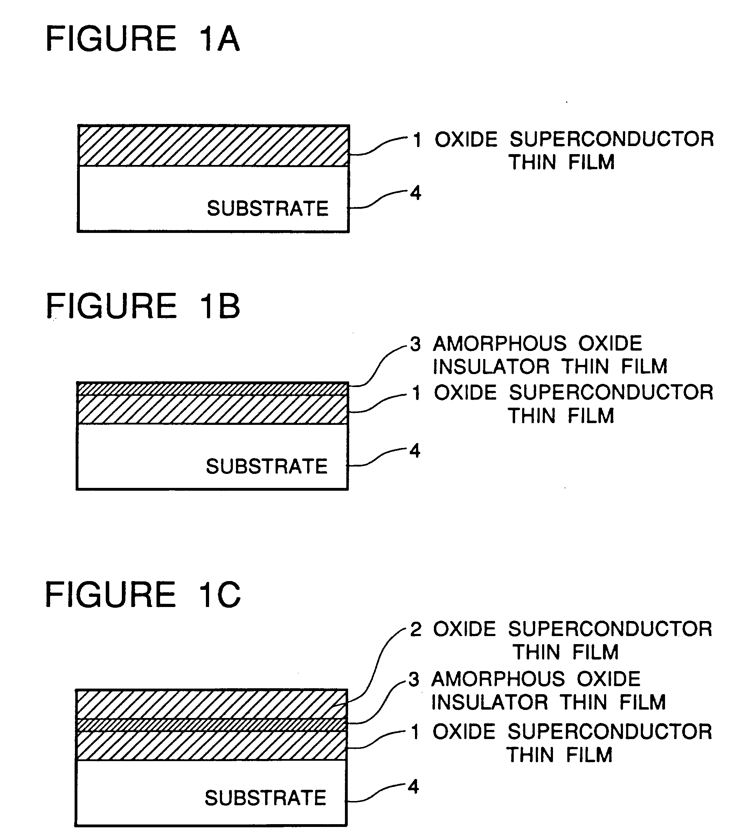

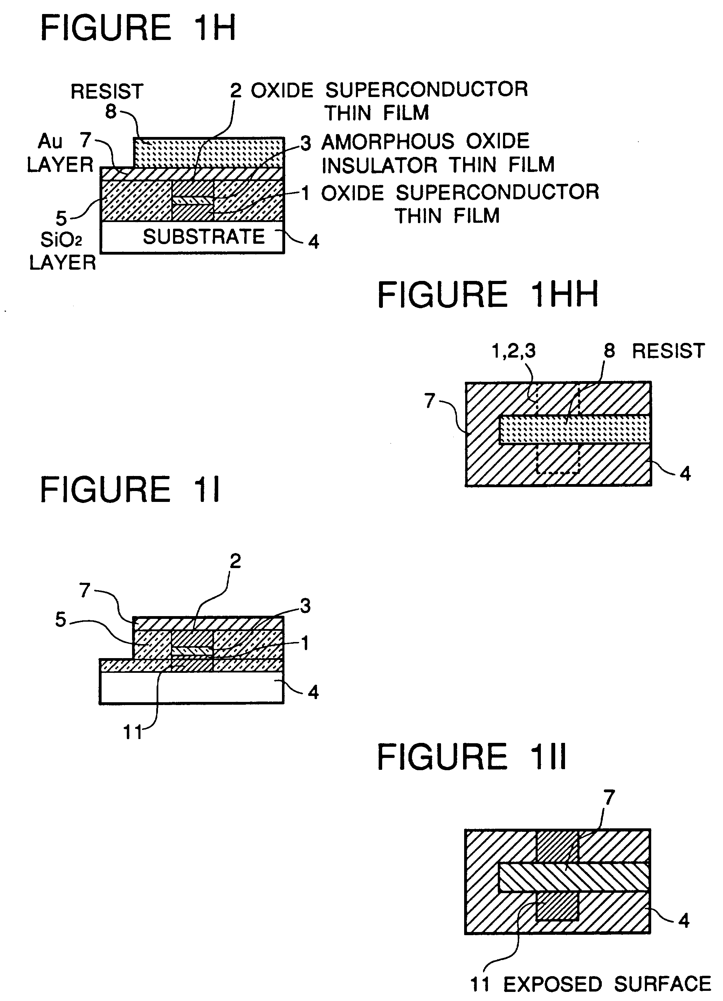

Figures 1A to 1II are diagrammatic sectional views for illustrating various steps of the first embodiment of the method in accordance with the present invention for manufacturing a superconducting device.

### Description of the Preferred embodiments

### Embodiment 1

A Josephson device was formed in accordance with the method of the present invention, by using a MgO substrate and Y₁Ba₂Cu₃O₇₋ₓ as an oxide superconductor material. The process will be described with reference to Figures 1A to 1II.

First, a first oxide superconductor material thin film 1 of Y₁Ba₂Cu₃O₇₋ₓ was deposited on a (100) surface of an MgO substrate 4 by sputtering. The deposition condition is as follows:

| | | |
|---|---|---|
| substrate temperature | | 700°C |
| sputtering gas | Ar | 4.5 SCCM |
| | O₂ | 0.5 SCCM |
| pressure | | 6.66 Pa (5 × 10⁻ Torr) |
| film thickness | | 400 nm |

Then, on the deposited first oxide superconductor material thin film 1, a thin film 3 of amorphous oxide was formed as shown in Figure 1B under the following conditions :

| | |
|---|---|
| atmosphere | water vapour |
| pressure | 6.66 × 10⁻³ Pa (5 × 10⁻⁵ Torr) |
| substrate temperature | 700 °C |
| treatment time | 15 minutes |

With the above treatment, the thickness of the thin film 3 of amorphous oxide thus formed was estimated a few mono-layers from the top surface. Thereafter, the substrate is allowed to cool down to 400 °C, and thereafter, an additional heat-treatment was performed under the following conditions :

| | |
|---|---|
| atmosphere | O₂ |
| pressure | 1.33 × 10⁴ Pa (100 Torr) |
| substrate temperature | 400 °C |
| treatment time | 1 hour |

Furthermore, a second thin film 2 of Y₁Ba₂Cu₃O₇₋ₓ was deposited on the amorphous oxide thin film 3 as shown on Figure 1C by a laser ablation method under the following conditions:

| | |
|---|---|
| substrate temperature | 630 °C |
| laser beam energy | 0.3 J/cm |
| oxygen pressure | 1.33 × 10³ Pa (10 Torr) |
| film thickness | 400 nm |

Thus, a three-layer structure as shown in Figure 1C was formed on the MgO substrate 4. At this stage, the first and second Y₁Ba₂Cu₃O₇₋ₓ oxide superconductor material thin films 1 and 2 were formed of a "*c*"-axis oriented crystal, and had the critical temperatures of 85K and 82K, respectively.

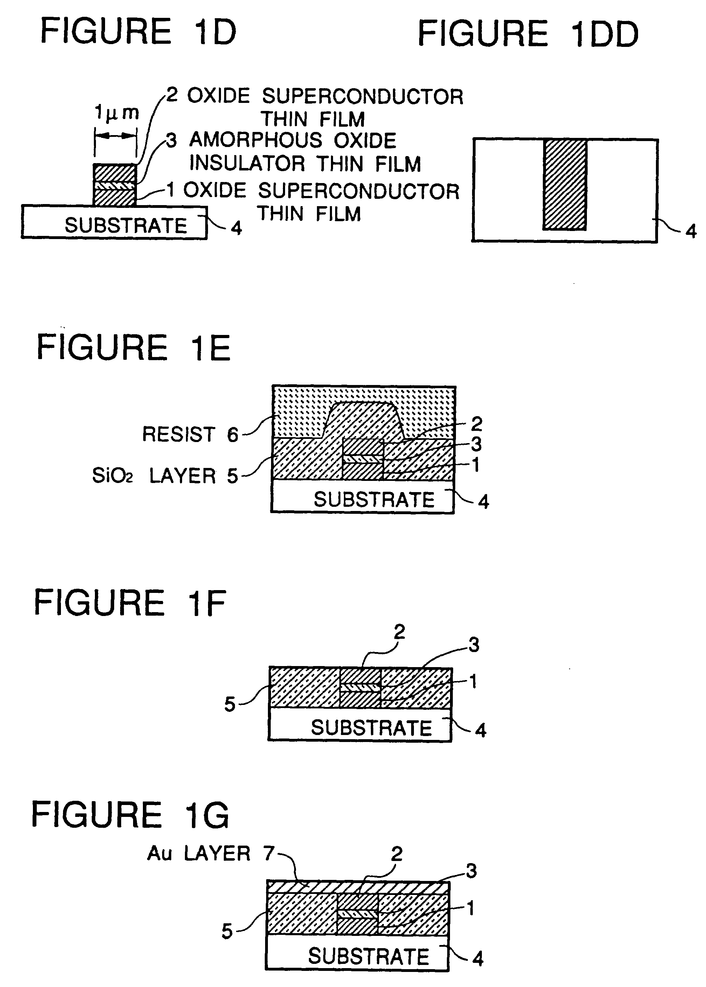

Thereafter, the three-layer structure as shown in Figure 1C was patterned by using a photolithography and an Ar-ion etching, so that a linear pattern having a width of 1 µm is formed as shown in Figures 1D and 1DD. Figure 1DD is a top plan view of the substrate shown in Figure 1D.

After the above mentioned patterning, a SiO₂ layer 5 having a thickness of 800 nm was deposited to cover the whole of the substrate, and a resist layer 6 was deposited to cover the SiO₂ layer 5, as shown in Figure 1E. Then, the deposited resist layer 6 and SiO₂ layer 5 were etched back by a reactive ion etching process, until an upper surface of the second oxide superconductor material thin film 2 is exposed as shown in Figure 1F.

Furthermore, an Au layer 7 was deposited so as to cover the whole of the upper surface of the substrate by a vacuum evaporation, as shown in Figure 1G. As shown in Figures 1H and 1HH, a patterned linear resist 8 was formed on the deposited Au layer 7 so as to intersect the linear patterned three-layer structure in the plan view shown in Figure 1HH. The patterned linear resist 8 was 1 µm in width.

An Ar-ion milling was performed using the patterned linear resist 8 as a mask, until the linear patterned three-layer structure which was not covered with the patterned linear resist 8 becomes about a half in thickness, namely until the lower or first oxide superconductor material thin film 1 has an exposed upper surface 11, as shown in Figures 1I and 1II. In addition, a metallization layer was formed on the exposed upper surface 11 of the lower or first oxide superconductor material thin film 1.

Thus, a Josephson device was completed, in which the patterned Au layer 7 forms one of a pair of electrodes, and the metallization layer formed on the exposed upper surface 11 of the lower or first oxide superconductor material thin film 1 forms the other of the pair of electrodes.

### Embodiment 2

The three-layer structure as shown in Figure 1C was formed in the same process as that of the Embodiment 1, except that a thin film 3 of amorphous oxide was formed as shown in Figure 1B under the following conditions:

| | |
|---|---|
| atmosphere | water vapour |
| pressure | 6.66 × 10⁻³ Pa (5 × 10⁻⁵ Torr) |
| substrate temperature | 550 °C |
| treatment time | 1 hour |

In this embodiment 2, the first and second Y₁Ba₂Cu₃O₇₋ₓ oxide superconductor material thin films 1 and 2 were formed of a "*c*"-axis oriented crystal, and had the critical temperatures of 86K and 82K, respectively.

The invention has thus been shown and described with reference to specific embodiments. However, it should be noted that the present invention is in no way limited to the details of the illustrated structures but changes and modifications may be made within the scope of the appended claims.

## Claims

1. A superconductor - insulator - superconductor (SIS) Josephson tunnel device comprising at least a first thin film (1) of oxide superconductor material formed on a substrate (4), a second thin film (3) of insulator material stacked on the first thin film of oxide superconductor material, and a third thin film (2) of the same oxide superconductor material as the first thin film (1) of oxide superconductor material and formed on the second thin film (3), so that a SIS tunnel type Josephson junction is formed of the first, second and third thin films (1, 3, 2), characterized in that the second thin film (3) of insulator material is formed of an amorphous oxide including the same constituent elements as those of the oxide superconductor material of the first and third thin films (1, 2).

2. A superconducting device as claimed in claim 1 wherein the second thin film (3) of amorphous oxide has a thickness estimated a few mono-layers of oxide superconductor surface.

3. A superconducting device as claimed in claim 1 wherein the first thin film (1) of oxide superconductor material is formed of a material selected from the group consisting of Y₁Ba₂Cu₃O_{7-X} (O≤x<1) and Bi₂Sr₂Ca₂Cu₃Oy (7≤y≤11).

4. A superconducting device as claimed in claim 1 wherein each of the first and third thin films (1,2) of oxide superconductor material is formed of a material selected from the group consisting of Y₁Ba₂Cu₃O_{7-X} (0≤x<1) and Bi₂Sr₂Ca₂Cu₃Oy (7≤y≤11).

5. A superconducting device as claimed in claim 5 wherein the second thin film (3) of amorphous oxide has a thickness estimated a few mono-layers of oxide superconductor surface.

6. A method for manufacturing a superconductor - insulator - superconductor (SIS) Josephson tunnel device comprising at least a first thin film (1) of oxide superconductor material formed on a substrate (4), a second thin film (3) of insulator material stacked on the first thin film (1) of oxide superconductor material, and a third thin film (2) of the same oxide superconductor material as the first thin film (1) of oxide superconductor material and formed on the second thin film (3), so that an SIS tunnel type Josephson junction is formed of the first, second and third thin films (1, 3, 2), characterized in that after the first thin film (1) of oxide superconductor material is formed on the substrate (4), the first thin film (1) of oxide superconductor material is heat-treated in a gaseous atmosphere so that the surface of the oxide superconductor material of the first thin film (1) is brought into an amorphous condition, whereby the second thin film (3) of insulator material is formed of an amorphous oxide including the same constituent elements as those of the oxide superconductor material of the first thin film (1).

7. A method as claimed in claim 6 wherein the heat-treatment is performed in a gaseous atmosphere including H₂O or CO₂, under a pressure in the range of 1.33 x 10⁻³ Pa (1 x 10⁻⁵ Torr) to 1.33 x 10⁻ Pa (1 x 10⁻⁴ Torr), and at a heating temperature in the extent of 400°C to 800°C.

8. A method as claimed in claim 6 wherein the heating temperature is in the extent of 400°C to 600°C.

9. A method as claimed in claim 6 wherein, after the heat-treatment is performed in the gaseous atmosphere for bringing the surface of the oxide superconductor material into the amorphous condition, an additional heat-treatment is performed in an oxygen atmosphere in order to improve the oxide superconductor material thin film deteriorated by the heat-treatment in the gaseous atmosphere.

10. A method as claimed in claim 7 wherein, after the heat-treatment is performed in the gaseous atmosphere including H₂O or CO₂, under a pressure in the range of 1.33 x 10⁻³Pa (1 x 10⁻⁵ Torr) to 1.33 x 10⁻ Pa (1 x 10⁻⁴ Torr), and at a heating temperature in the extent of 400°C to 800°C so that the surface of the oxide superconductor material is brought into the amorphous condition, an additional heat-treatment is performed in an oxygen atmosphere under a pressure in the range of 6.66 x 10³ to 2.67 10⁻⁴ x Pa 50 Torr to 200 Torr), and at a heating temperature in the range of 400°C to 500°C, in order to improve the oxide superconductor material thin film deteriorated by the heat-treatment in the gaseous atmosphere.

11. A method as claimed in claim 7 wherein after the second thin film of amorphous oxide is formed, a third thin film of the same oxide superconductor material as that of the first thin film is deposited on the second thin film of amorphous oxide, so that a tunnel type Josephson junction is formed of the first, second and third thin films.

## Patentansprüche

1. Supraleiter-Isolator-Supraleiter (SIS) Josephson-Tunnelanordnung mit wenigstens einer ersten Dünnschicht (1) aus oxydischem supraleitendem Material, die auf einem Substrat (4) ausgebildet ist, mit einer zweiten Dünnschicht (3) aus isolierendem Material, die auf der ersten Dünnschicht aus oxydischem supraleitendem Material aufgebracht ist und mit einer dritten Dünnschicht (2) aus dem gleichen oxydischen supraleitenden Material wie die erste Dünnschicht (1) aus oxydischem supraleitendem Material, die auf der zweiten Dünnschicht (3) ausgebildet ist, so daß ein Josephson-Tunnelübergang vom SIS-Typ durch die ersten, zweiten und dritten Dünnschichten (1,3,2) gebildet wird, **dadurch gekennzeichnet**, daß die zweite Dünnschicht (3) aus isolierendem Material aus einem amorphen Oxyd besteht, welches die gleichen Bestandselemente enthält wie diejenigen des oxydischen supraleitenden Materials der ersten und dritten Dünnschichten (1,2).

2. Supraleitende Anordnung nach Anspruch 1, bei der die zweite Dünnschicht (3) aus amorphem Oxyd eine Dicke aufweist von schätzungsweise einigen wenigen Monoschichten einer oxydischen supraleitenden Oberfläche.

3. Supraleitende Anordnung nach Anspruch 1, bei der die erste Dünnschicht (1) aus oxydischem supraleitendem Material gebildet ist aus einem Material, das ausgewählt ist aus der Gruppe bestehend aus Y₁Ba₂Cu₃O_{7-X} (0≤x<1) und Bi₂Sr₂Ca₂Cu₃Oy (7≤y≤11).

4. Supraleitende Anordnung nach Anspruch 1, bei der die ersten und die dritten Dünnschichten (1,2) aus oxydischem supraleitendem Material aus einem Material bestehen, das ausgewählt ist aus der Gruppe bestehend aus Y₁Ba₂Cu₃O_{7-X} (0≤x<1) und Bi₂Sr₂Ca₂Cu₃Oy (7≤y≤1).

5. Supraleitende Anordnung nach Anspruch 5, bei der die zweite Dünnschicht (3) aus amorphem Oxyd eine Dicke aufweist von schätzungsweise einigen wenigen Monoschichten einer oxydischen supraleitenden Oberfläche.

6. Verfahren zur Herstellung einer Supraleiter-Isolator-Supraleiter (SIS) Josephson-Tunnelanordnung, mit wenigstens einer ersten Dünnschicht (1) aus oxydischem supraleitendem Material, die auf einem Substrat (4) aufgebracht ist, mit einer zweiten Dünnschicht (3) aus isolierendem Material, die auf der ersten Dünnschicht (1) aus oxydischem supraleitendem Material ausgebildet ist und mit einer dritten Dünnschicht (2) aus dem gleichen oxydischen supraleitenden Material wie die erste Dünnschicht (1) aus oxydischem supraleitendem Material, die auf der zweiten Dünnschicht (3) ausgebildet ist, so daß ein SIS-Josephson-Übergang vom Tunneltyp durch die ersten, zweiten und dritten Dünnschichten (1,3,2) gebildet wird, **dadurch gekennzeichnet**, daß nach der Ausbildung der ersten Dünnschicht (1) aus oxydischem supraleitendem Material auf dem Substrat (4) die erste Dünnschicht (1) aus oxydischem supraleitendem Material in einer Gasatmosphäre wärmebehandelt wird, so daß die Oberfläche des oxydischen supraleitenden Materials der ersten Dünnschicht (1) in einen amorphen Zustand übergeht, während die zweite Dünnschicht (3) aus isolierendem Material aus einem amorphen Oxyd besteht, welches die gleichen Bestandselemente enthält wie das oxydische supraleitende Material der ersten Dünnschicht (1).

7. Verfahren nach Anspruch 6, bei dem die Wärmebehandlung in einer Gasatmosphäre durchgeführt wird, welche H₂O oder CO₂ enthält, unter einem Druck im Bereich von 1,33 x 10⁻³ Pa (1 x 10⁻⁵ Torr) bis 1,33 x 10⁻ Pa (1 x 10⁻⁴ Torr), bei einer Heiztemperatur im Bereich von 400°C bis 800°C.

8. Verfahren nach Anspruch 6, bei dem die Heiztemperatur im Bereich von 400°C bis 600°C liegt.

9. Verfahren nach Anspruch 6, wobei nach der Durchführung der Wärmebehandlung in der Gasatmosphäre, um die Oberfläche des oxydischen supraleitenden Materials in den amorphen Zustand zu überführen, eine zusätzliche Wärmebehandlung in einer Sauerstoffatmosphäre durchgeführt wird, um die durch die Wärmebehandlung in der Gasatmosphäre gestörte Dünnschicht aus dem oxydischen supraleitenden Material zu verbessern.

10. Verfahren nach Anspruch 7, bei dem nach der Durchführung der Wärmebehandlung in der Gasatmosphäre, die H₂O oder CO₂ enthält, bei einem Druck im Bereich von 1,33 x 10^{-3Pa} (1 x 10⁻⁵ Torr) bis 1,33 x 10⁻ Pa (1 x 10⁻⁴ Torr) und bei einer Heiztemperatur im Bereich von 400°C bis 800°C, so daß die Oberfläche des oxydischen supraleitenden Materials in den amorphen Zustand übergeht, eine zusätzliche Wärmebehandlung durchgeführt wird in einer Sauerstoffatmosphäre bei einem Druck im Bereich von 6,66 x 10⁻³ bis 2,67 x 10⁻⁴Pa (50 Torr bis 200 Torr) bei einer Heiztemperatur im Bereich von 400°C bis 500°C, um die durch die Wärmebehandlung in der Gasatmosphäre gestörte Dünnschicht aus dem oxydischen supraleitenden Material zu verbessern.

11. Verfahren nach Anspruch 7, bei dem nach der Ausbildung der zweiten Dünnschicht aus amorphem Oxyd eine dritte Dünnschicht aus dem gleichen oxydischen supraleitenden Material wie die erste Dünnschicht auf der zweiten Dünnschicht aus amorphem Oxyd abgeschieden wird, so daß ein JosephsonTunnelübergang durch die ersten, zweiten und dritten Dünnschichten gebildet wird.

## Revendications

1. Dispositif tunnel de Josephson du type supraconducteur-isolant-supraconducteur (SIS) comportant au moins un premier film mince (1) matériau d'oxyde supraconducteur formé sur un substrat (4), un deuxième film mince (3) de matériau isolant empilé sur le premier film mince de matériau d'oxyde supraconducteur, et un troisième film mince (2) du même matériau d'oxyde supraconducteur que le premier film mince (1) de matériau d'oxyde supraconducteur et formé sur le deuxième film mince (3), de sorte qu'une jonction Josephson du type tunnel SIS est formée des premier, deuxième et troisième films minces (1, 3, 2), caractérisé en ce que le deuxième film mince (3) de matériau isolant est formé d'un oxyde amorphe comportant les mêmes éléments constitutifs que ceux du matériau d'oxyde supraconducteur du premier et du troisième film mince (1, 2).

2. Dispositif supraconducteur selon la revendication 1, dans lequel le deuxième film mince (3) d'oxyde amorphe a une épaisseur estimée à quelques monocouches de surface de supraconducteur d'oxyde.

3. Dispositif supraconducteur selon la revendication 1, dans lequel le premier film mince (1) de matériau d'oxyde supraconducteur est formé d'un matériau choisi parmi le groupe constitué de Y₁Ba₂Cu₃O₇₋ₓ (0 ≤ x < 1) et Bi₂Sr₂Ca₂Cu₃Oy (7 ≤ y ≤ 11).

4. Dispositif supraconducteur selon la revendication 1 dans lequel chacun du premier et du troisième film mince (1, 2) de matériau d'oxyde supraconducteur est formé d'un matériau choisi parmi le groupe constitué de Y₁Ba₂Cu₃O₇₋ₓ (0 ≤x ≤ 1) et Bi₂Sr₂Ca₂Cu₃Oy (7 ≤ y ≤ 11).

5. Dispositif supraconducteur selon la revendication 5, dans lequel le deuxième film mince (3) constitué d'oxyde amorphe a une épaisseur estimée à quelques monocouches de surface de supraconducteur d'oxyde.

6. Procédé pour fabriquer un dispositif tunnel de Josephson du type supraconducteur-isolant-supraconducteur (SIS) comportant au moins un premier film mince (1) de matériau d'oxyde supraconducteur formé sur un substrat (4), un deuxième film mince (3) de matériau isolant empilé sur le premier film mince (1) de matériau d'oxyde supraconducteur, et un troisième film mince (2) constitué du même matériau d'oxyde supraconducteur que le premier film mince (1) de matériau d'oxyde supraconducteur et formé sur le deuxième film mince (3), de sorte qu'une jonction Josephson du type tunnel SIS est formée des premier, deuxième et troisième films minces (1, 3, 2), caractérisé en ce qu'après que le premier film mince (1) de matériau d'oxyde supraconducteur ait été formé sur le substrat (4), le premier film mince (1) de matériau d'oxyde supraconducteur est traité thermiquement dans une atmosphère gazeuse de sorte que la surface de matériau d'oxyde supraconducteur du premier film mince (1) est amenée dans un état amorphe, alors que le deuxième film mince (3) de matériau isolant est formé d'un oxyde amorphe comportant les mêmes éléments constitutifs que ceux du matériau d'oxyde supraconducteur du premier film mince (1).

7. Procédé selon la revendication 6, dans lequel le traitement thermique est réalisé dans une atmosphère gazeuse comportant H₂O ou CO₂, sous une pression située dans la plage allant de 1,33 x 10⁻³ à 1,33 x 10⁻ Pa (1 x 10⁻⁵ à 1 x 10⁻⁴ Torr), et à une température de chauffage située dans la plage allant de 400°C à 800°C.

8. Procédé selon la revendication 6, dans lequel la température de chauffage est dans la plage de 400°C à 600°C.

9. Procédé selon la revendication 6, dans lequel, après que le traitement thermique ait été réalisé sous atmosphère gazeuse pour amener à l'état amorphe la surface du matériau d'oxyde supraconducteur, un traitement thermique supplémentaire est réalisé dans une atmosphère d'oxygène afin d'améliorer le film mince de matériau d'oxyde supraconducteur détérioré par le traitement thermique sous atmosphère gazeuse.

10. Procédé selon la revendication 7, dans lequel, après que le traitement thermique ait été réalisé sous atmosphère gazeuse comportant H₂O ou CO₂, sous une pression située dans la plage allant de 1,33 x 10⁻³ à 1,33 x 10⁻ Pa (1 x 10⁻⁵ à 1 x 10⁻⁴ Torr), et à une température de chauffage située dans la plage allant de 400°C à 800°C, de sorte que la surface du matériau d'oxyde supraconducteur est amenée à l'état amorphe, un traitement thermique supplémentaire est réalisé dans une atmosphère d'oxygène sous une pression située dans la plage allant de 6,66 x 10³ à 2,67 x 10⁴ Pa (50 à 200 Torr), et à une température de chauffage située dans la plage allant de 400°C à 500°C, afin d'améliorer le film mince de matériau d'oxyde supraconducteur détérioré par le traitement thermique sous atmosphère gazeuse.

11. Procédé selon la revendication 7, dans lequel après que le deuxième film mince d'oxyde amorphe ait été formé, un troisième film mince constitué du même matériau d'oxyde supraconducteur que celui du premier film mince est déposé sur le deuxième film mince d'oxyde amorphe, de sorte qu'une jonction Josephson du type tunnel est formée des premier, deuxième et troisième films minces.
